# FASCICULE DE BREVET EUROPEEN

(11) **EP 3 209 098 B1**
(45) Date de publication et mention de la délivrance du brevet: **12.07.2023**
(21) Numéro de dépôt: 17155663.2
(22) Date de dépôt: 10.02.2017
(51) Int. Cl.: H05K 1/02, H05K 1/18, H05K 3/00, F21S 45/47

(54) **MODULE LUMINEUX POUR UN VÉHICULE AUTOMOBILE AVEC REPRISE DE MASSE**
LEUCHTMODUL FÜR KRAFTFAHRZEUG MIT ERDUNG
LIGHT MODULE FOR A MOTOR VEHICLE WITH GROUND SOCKET

(30) Priorité: 22.02.2016 FR 1651409
(43) Date de publication de la demande: 23.08.2017
(73) Titulaire: Valeo Vision, 93012 Bobigny Cedex (FR)
(72) Inventeur: BADIA, Olivier, 94350 Villiers sur Marne (FR)
(74) Mandataire: Valeo Visibility

(56) Documents cités:
- DE-A1-102008 055 683
- JP-A- 2012 038 894
- US-A1- 2007 212 906
- US-A1- 2008 253 145
- US-A1- 2009 032 295
- US-A1- 2014 231 793

## Description

L'invention a trait au domaine de l'éclairage et de la signalisation lumineuse, notamment pour véhicule automobile.

Dans le domaine de l'éclairage et de la signalisation lumineuse pour véhicules automobiles, il devient de plus en plus courant d'utiliser des sources lumineuses à composants semi-conducteurs électroluminescents, par exemple des diodes électroluminescentes, LED. Un composant LED émet des rayons lumineux lorsqu'une tension d'une valeur au moins égale à une valeur seuil appelée tension directe est appliquée à ces bornes.

De manière connue, une ou plusieurs LEDs d'un module lumineux pour un véhicule automobile sont alimentées par le biais de moyens de pilotage de l'alimentation, qui comprennent des circuits convertisseurs. Les moyens de pilotage de l'alimentation sont configurés pour convertir un courant électrique d'une première intensité, par exemple fourni par une source de courant du véhicule automobile, telle qu'une batterie, en un courant de charge ayant une deuxième intensité, différente de la première. Les circuits électroniques réalisant les moyens de pilotage de l'alimentation, ainsi que les circuits comprenant les sources lumineuses elles-mêmes peuvent de manière connue être réalisés sur des circuits imprimés à substrat flexible, (« flexible printed circuit board ») FPCB. Par rapport à des circuits imprimés à substrat rigide, un FPCB présente l'avantage d'être pliable, ce qui facilite sa disposition dans le volume restreint disponible au sein d'un dispositif lumineux d'un véhicule automobile. Les circuits électroniques réalisés sur une face d'un FPCB peuvent néanmoins nécessiter une reprise du potentiel zéro, ou de la masse. A cet effet, il est par exemple connu de prévoir des rivets électriquement conducteurs qui percent le substrat flexible à des endroits prédéterminés, et contactent un élément mis à la masse. La surface utilisable du circuit imprimé est donc occupée en partie par des composants dont l'unique fonction est la reprise de masse.

JP 2012 038894 et US 2009/032295 décrivent un module lumineux pour un véhicule automobile selon le préambule de la revendication 1.

L'invention a pour objectif de proposer une solution palliant à au moins un des désavantages susmentionnés. Plus particulièrement l'invention propose un module lumineux impliquant un circuit imprimé à substrat flexible, FPCB, qui permet une reprise de masse en limitant le volume occupé par les éléments qui réalisent la reprise de masse par rapport à des solutions connues.

L'invention a pour objet un module lumineux pour un véhicule automobile. Le module lumineux comprend un dispositif métallique représentant la masse, et un ensemble comprenant un circuit imprimé à substrat flexible, FPCB, abritant un circuit électronique. Le module lumineux comprend également au moins une plaque de support. L'ensemble est disposé sur une surface du dispositif métallique. Le substrat flexible comprend une première portion de substrat qui supporte sur une première face les composants électroniques du circuit électronique, et qui est en contact, par une deuxième face opposée à la première face, avec ladite plaque de support de façon à ce que la première portion de substrat soit rigidifiée. Le module lumineux est remarquable en ce que le substrat flexible comprend une deuxième portion de substrat qui comprend au moins une trace électriquement conductrice sur une première face, et qui est délimitée par un pli unique du substrat par rapport à la première portion de substrat, le pli étant tel que la deuxième portion de substrat est en contact avec ladite plaque de support et tel que la trace électriquement conductrice réalise une reprise de masse. La plaque de support comprend deux parties qui s'étendent dans des plans généralement parallèles à la surface du dispositif métallique, comprenant :
- une première partie dont une première face est en contact avec la deuxième face de la première portion de substrat et dont une deuxième face, opposée à la première, est en contact avec la surface du dispositif métallique, et
- une deuxième partie en contact avec la trace électriquement conductrice de la première face de la deuxième portion de substrat.

La première portion de substrat peut avoir la forme d'une bande ayant une longueur et une largeur, la largeur étant moins importante que la longueur. La deuxième partie peut être prévue sous la forme d'une languette élargissant la largeur du substrat sur une partie de la longueur.

De préférence, la plaque de support est plus rigide que le substrat flexible.

Selon un exemple ne faisant pas partie de l'invention,la deuxième portion de substrat peut être pliée en direction de la deuxième face de la première portion de substrat.

La plaque de support peut être enveloppée par la première et la deuxième portion de substrat.

La trace électriquement conductrice de la première face de la deuxième portion de substrat peut être en contact électrique avec la surface du dispositif métallique.

La plaque de support peut de préférence comprendre de l'aluminium.

Le pli du substrat peut préférentiellement être tel que la première portion de substrat et la deuxième portion de substrat s'étendent l'une à côté de l'autre dans des plans généralement parallèles à la surface du dispositif métallique.

De préférence, la plaque de support peut comprendre une ouverture permettant le passage du substrat flexible au niveau du pli. Il peut par exemple s'agir d'une fente. Le dispositif métallique peut de préférence faire partie de moyens de dissipation thermique du module. Il peut par exemple s'agir d'un radiateur destiné à dissiper la chaleur produite par les composants électroniques du circuit électronique.

De préférence, les contacts entre le substrat et la plaque de support et/ou la surface du dispositif métallique peuvent être réalisés à l'aide d'une colle thermiquement conductrice. Les contacts entre la plaque de support et le substrat et/ou la surface du dispositif métallique peuvent préférentiellement être réalisés à l'aide d'une colle thermiquement conductrice. La colle est avantageusement électriquement conductrice.

Le substrat flexible ou la plaque de support peuvent de préférence être fixés au dispositif métallique à l'aide d'au moins un rivet perçant le substrat ou la plaque de support. La fixation peut être réalisée par sertissage moyennant un pion..

De préférence, le circuit électronique peut comprendre des moyens de pilotage de l'alimentation d'au moins une source lumineuse du module lumineux. Le circuit électronique peut de préférence comprendre au moins une source lumineuse, par exemple à élément semi-conducteur. Il peut par exemple s'agir d'une diode électroluminescente LED ou d'une diode laser.

En utilisant les mesures selon la présente invention, il devient possible de réaliser une reprise de masse pour un circuit électronique implanté sur un côté d'un circuit imprimé de type FPCB, en utilisant la flexibilité du substrat du circuit imprimé, et sans avoir recours à des composants supplémentaires dédiés à cet effet. De ce fait, la solution proposée par l'invention permet de réaliser une reprise de masse en utilisant moins de pièces en comparaison à des solutions existantes. Par rapport à des solutions connues, l'invention évite la pose manuelle de deux rivets sur le circuit imprimé flexible et fragile, et évite la nécessité de retourner ce dernier moyennant par deux plis. Ceci implique un coût de réalisation moins important ainsi qu'un gain de volume dans l'espace restreint disponible pour la conception d'un dispositif lumineux pour un véhicule automobile.

D'autres caractéristiques et avantages de la présente invention seront mieux compris à l'aide de la description et des dessins parmi lesquels :
- la figure 1 montre une illustration schématique d'une coupe latérale à travers un substrat flexible et une plaque de support dans un exemple ne faisant pas partie de l'invention ;
- la figure 2 montre une illustration en perspective d'un module lumineux selon un exemple ne faisant pas partie de l'invention ;
- la figure 3 montre une coupe selon l'axe A-A du module illustré par la figure 2 ;
- les figures 4a et 4b montrent un détail, notamment un substrat flexible, selon un exemple ne faisant pas partie de l'invention ;
- la figure 5 montre une illustration schématique d'une coupe latérale à travers un substrat flexible et une plaque de support dans un mode de réalisation préféré d'un module lumineux selon l'invention ;
- la figure 6 montre un détail, notamment une plaque de support, selon un mode de réalisation préféré de l'invention ;
- la figure 7 montre une illustration en perspective d'un module lumineux selon un mode de réalisation préféré de l'invention.

Dans la description qui suit, des numéros de référence similaires seront utilisées pour décrire des concepts similaires à travers des modes de réalisation différents de l'invention. Ainsi, les numéros de référence 300, 400 décrivent un module lumineux dans quatre modes de réalisation différents conformes à l'invention.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif.

Les éléments montrés sur les dessins ne sont pas à l'échelle et sont simplifiées pour augmenter la clarté de l'exposé.

Des circuits imprimés à substrat flexible de type FPCB sont en soi connus dans l'art. Leur production ne sera pas décrite en détails dans le cadre de la présente invention. Typiquement, les composants d'un circuit électronique implanté sur un circuit imprimé de type FPCB sont disposés sur une première face du substrat et reliés par des pistes électriquement conductrices prévues sur la surface du substrat. Afin de garantir la durabilité d'un tel montage, le substrat flexible est de manière connue localement rigidifié par collage d'une plaque de support sur la deuxième face du substrat flexible, qui est la face opposée à la face qui supporte le circuit électronique du substrat flexible.

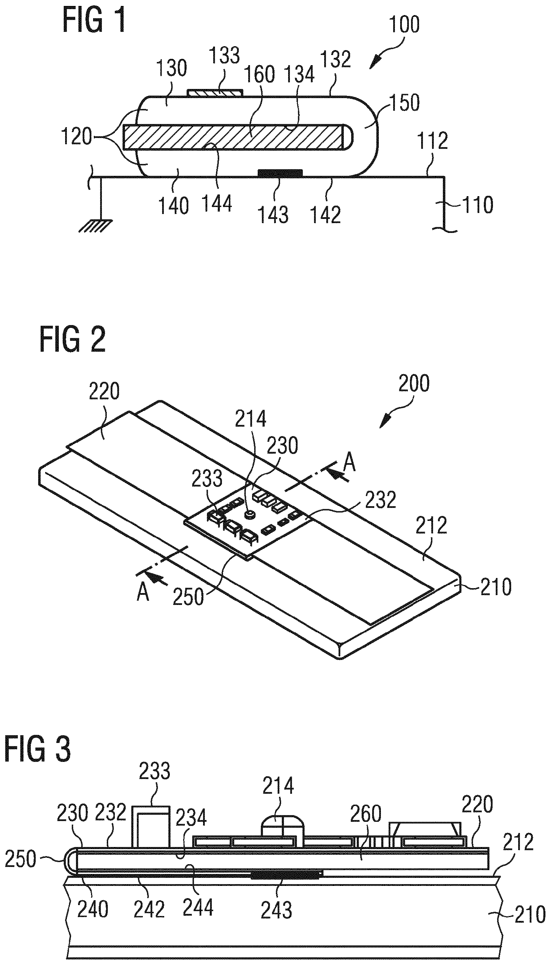

La figure 1 schématise un module lumineux 100 selon un exemple ne faisant pas partie de l'invention. Une coupe latérale est montrée. Uniquement les composants essentiels pour la compréhension de l'invention sont montrés. Un module lumineux peut cependant comprendre d'autres composants que ceux qui sont illustrés. Le module comprend un dispositif métallique 110 représentant la masse. Avantageusement, il s'agit d'un moyen de dissipation thermique du module lumineux, par exemple d'un radiateur en métal, tel que l'Aluminium. Le module comprend un ensemble qui regroupe un circuit imprimé à substrat flexible 120 et une plaque de support 160. La plaque de support est destinée à rigidifier le substrat flexible à l'endroit correspondant à l'emplacement des composants d'un circuit électronique. Idéalement, la plaque de support est collée au substrat. L'épaisseur du substrat flexible 120 est exagérée par rapport à l'épaisseur de la plaque pour des raisons de clarté de l'exposé. Le circuit imprimé de type FPCB abrite un circuit électronique dont les composants électroniques 133 sont montrés. Il s'agit par exemple de sources lumineuses de type diode électroluminescente, LED. L'ensemble est disposé sur une surface 112 du dispositif métallique. Les composants électroniques 133 sont supportées sur une première face 132 d'une première portion de substrat 130. La deuxième face 134 de la première portion de substrat, opposée à la première face 132, est en contact avec la plaque de support 160. Le substrat flexible comprend une deuxième portion de substrat 140 ayant une première face 142 et une deuxième face 144. Dans l'état aplati du substrat, les premières faces 132 et 142 des première et deuxième portions de substrat forment une surface continue dans un même plan. Sur la figure 1, la deuxième portion de substrat 140 est pliée par rapport à la première portion de substrat 130. Un pli unique 150 délimite les deux portions. Le pli est tel que la deuxième portion de substrat entre en contact, en particulier par sa deuxième surface 144, avec la plaque de support et par sa première surface 142 avec le dispositif métallique. Comme cette première surface 142 comporte une trace électriquement conductrice 143 reliée au circuit électronique, une reprise de masse est ainsi réalisée sans utiliser des composants supplémentaires.

La figure 2 montre une vue en perspective d'une variante du mode de réalisation montré par la figure 1. Le module 200 comprend un dispositif métallique 210 représentant la masse. Le module comprend un ensemble qui regroupe un circuit imprimé à substrat flexible 220 et une plaque de support non visible. Le circuit imprimé de type FPCB abrite un circuit électronique dont les composants électroniques 233 sont montrés. L'ensemble est disposé sur une surface 212 du dispositif métallique. Les composants électroniques 233 sont supportés sur une première face 232 d'une première portion de substrat 230. Un pli 250 relie la première portion de substrat à une deuxième portion non visible sur la figure 2. Un rivet de fixation 214 est prévu pour fixer l'ensemble sur le dispositif métallique. Il n'est pas nécessaire que le rivet, ou pion de sertissage, soit électriquement conducteur.

La figure 3 montre une coupe du module 200 au niveau de la ligne A-A. On y aperçoit la plaque de support 260, qui est enveloppée en partie par la première portion de substrat 230, le pli 250 et la deuxième partie de substrat 240. La deuxième face 234 de la première portion de substrat 230 est en contact avec la plaque de support 260. Idéalement, une colle thermiquement conductrice est prévue à cette interface. La deuxième portion de substrat 240 est repliée en direction de la deuxième face 234 de la première portion 230, de façon à envelopper la plaque de support 260, qui est contactée par la deuxième face 244 de la deuxième portion de substrat 240. Sur la première face 242 de la deuxième portion de substrat, qui est en contact avec la surface 212 du dispositif métallique 210, est prévue une trace électriquement conductrice 243 reliée au circuit électronique abrité sur le substrat 220. Cette disposition réalise la reprise de masse sans composants spécifiques dédiés à cet effet. Idéalement, une colle thermiquement conductrice est prévue à l'interface des surfaces 212 et 242, afin de garantir un échange de chaleur entre le substrat 220 et l'élément métallique 210.

Lors du montage du module 200, on effectue d'abord la pose des composants électroniques 233 sur le substrat, dont la première portion 230 est ensuite collée sur la plaque de support 260, dont les dimensions (largeur, longueur) sont avantageusement sensiblement égales à celles de la première portion de substrat 230. La deuxième portion 240 du substrat est ensuite repliée sur la plaque de support et collée à celle-ci. L'ensemble est alors fixé, par collage et/ou sertissage au radiateur 210.

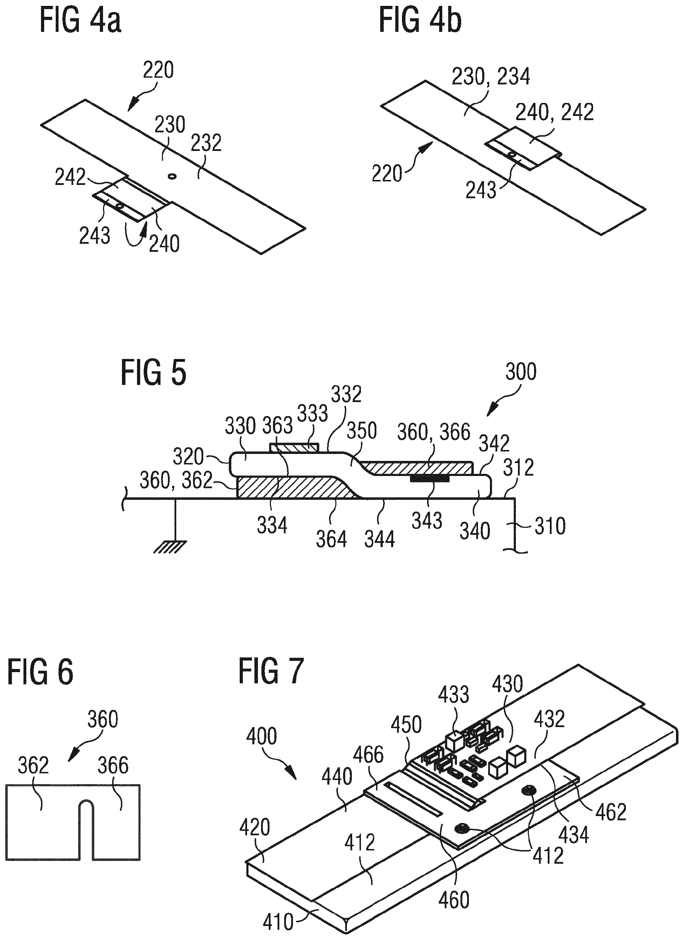

La figure 4a montre le substrat flexible 220 dans un état déplié vu d'en haut. Ni la plaque de support, ni le dispositif métallique ne sont illustrés. Le substrat 220 comprend une première portion 230 et une deuxième portion 240. La première face du substrat est également séparée en une première portion 232 et une deuxième portion 242. La première face de la deuxième portion de substrat 242 comprend la trace électriquement conductrice destinée à contacter l'élément métallique représentant la masse. La figure 4b reprend le substrat flexible 220 vu d'en bas, dans un état plié. En particulier, la languette représentant la deuxième portion de substrat 240 est repliée en direction de la deuxième face 234 de la première portion de substrat.

La figure 5 schématise un module lumineux 300 selon un autre mode de réalisation conforme à l'invention. Une coupe latérale est montrée. Seuls les composants essentiels pour la compréhension de l'invention sont montrés. Le module comprend un dispositif métallique 310 représentant la masse. Avantageusement, il s'agit d'un moyen de dissipation thermique du module lumineux, par exemple d'un radiateur en métal, tel que l'Aluminium. Le module comprend un ensemble qui regroupe un circuit imprimé à substrat flexible 320 et une plaque de support 360 électriquement conductrice. La plaque de support est destinée à rigidifier le substrat flexible à l'endroit correspondant à l'emplacement des composants d'un circuit électronique. Idéalement, la plaque de support est collée au substrat. L'épaisseur du substrat flexible 320 est exagérée par rapport à l'épaisseur de la plaque pour des raisons de clarté de l'exposé. Le circuit imprimé de type FPCB abrite un circuit électronique dont les composant électroniques 333 sont montrés. Il s'agit par exemple de sources lumineuses de type diode électroluminescente, LED. L'ensemble est disposé sur une surface 312 du dispositif métallique. Les composants électroniques 333 sont supportées sur une première face 332 d'une première portion de substrat 330. La deuxième face 334 de la première portion de substrat, opposée à la première face 332, est en contact avec la plaque de support 360. Le substrat flexible comprend une deuxième portion de substrat 340 ayant une première face 342 et une deuxième face 344. Dans l'état aplati du substrat, les premières faces 332 et 342 des première et deuxième portions de substrat forment une surface continue dans un même plan. Sur la figure 5, la deuxième portion de substrat 340 est pliée par rapport à la première portion de substrat 330. Un pli unique 350 délimite les deux portions. Le pli 350 est tel que la première portion de substrat 330 et la deuxième portion de substrat 340 s'étendent l'un à côté de l'autre dans des plans généralement parallèles à la surface du dispositif métallique 312. Les plans se situent à des hauteurs différentes par rapport à la surface 312.

D'une part, la deuxième face 334 de la première portion de substrat 330 est en contact avec une première partie de la plaque de support 363, qui est entreposée entre la surface 312 et le substrat 320. La deuxième face 334 de la première portion de substrat est en contact avec la première face 363 de la première partie 362 de la plaque de support. La deuxième face 364 de la première portion de substrat, est en contact avec la surface 312. Les interfaces respectives sont idéalement pourvues d'une couche de colle thermiquement conductrice.

D'autre part, la première face 342 de la deuxième portion de substrat 340 est en contact avec une deuxième partie de la plaque de support 366. La deuxième portion de substrat 340 est interposée entre la surface 312 et la plaque de support. Idéalement les interfaces respectives sont pourvues d'une colle thermiquement et électriquement conductrice. La disposition est telle que la première face 342 comprend une trace électriquement conductrice 343 qui est en contact avec la plaque de support 360. La première partie 362 de la plaque de support électriquement conductrice est reliée à la masse par son contact avec la surface 312. La reprise de masse est donc effectuée par la trace électriquement conductrice 343 qui est en contact avec la deuxième partie 366 de la plaque de support.

La figure 6 montre une vue d'en haut d'une plaque de support 360 comprenant les deux parties décrites 362 et 366 respectivement. La plaque de support est de préférence une plaque métallique, par exemple une plaque en Aluminium. Les deux parties de la plaque sont de préférence séparées par une ouverture, telle qu'une fente qui permet le passage du substrat flexible, tandis que les deux parties sont électriquement reliées.

La figure 7 montre une vue en perspective d'une variante du mode de réalisation montré par la figure 5. Le module 400 comprend un dispositif métallique 410 représentant la masse. Le module comprend un ensemble qui regroupe un circuit imprimé à substrat flexible 420 et une plaque de support 460 ayant deux parties 462, 466 distinctes. Le circuit imprimé de type FPCB abrite un circuit électronique dont les composants électroniques 433 sont montrés. L'ensemble est disposé sur une surface 412 du dispositif métallique. Les composants électroniques 433 sont supportés sur une première face 432 d'une première portion de substrat 430. La première portion de substrat 430 est rigidifiée par la première partie 462 de la plaque de support 460. Un pli 450 relie la première portion de substrat à une deuxième portion 440. En direction de droite à gauche sur la figure 7, le pli fait passer le substrat 460 en-dessous de la deuxième partie 466 de la plaque de support 460. Au moins un rivet de fixation 412 est prévu pour fixer l'ensemble sur le dispositif métallique. Il n'est pas nécessaire que le rivet, ou pion de sertissage, soit électriquement conducteur. Le ou les rivets peuvent se situer au niveau du substrat, ou, comme illustré sur une portion de la plaque de support qui relie les deux parties de celles-ci. L'illustration montre que les deux parties de la plaque de support s'étendent dans un même plan.

Lors du montage du module 400, on effectue d'abord la pose des composants électroniques 433 sur le substrat. Le substrat est ensuite plié afin qu'on puisse coller la première portion 430 sur la première partie 462 de la plaque de support 260. La deuxième portion 440 du substrat est ensuite passée à travers l'ouverture de la plaque de support pour être collée en-dessous de la deuxième partie 266 de la plaque de support. L'ensemble est alors fixé, par collage et/ou sertissage au dispositif métallique 410.

## Revendications

1. Module lumineux (300, 400) pour un véhicule automobile comprenant
un ensemble comprenant un circuit imprimé à substrat flexible (320, 420), FPCB, abritant un circuit électronique, et au moins une plaque de support (360, 460) électriquement conductrice, dans lequel le substrat flexible comprend
une première portion de substrat (330, 430) qui supporte sur une première face (332, 432) au moins un composant électronique (333, 433) du circuit électronique, et qui est en contact, par une deuxième face (334, 434) opposée à la première face, avec ladite plaque de support (360, 460) de façon à ce que la première portion de substrat soit rigidifiée,
le substrat flexible comprenant une deuxième portion de substrat (340, 440) qui comprend au moins une trace électriquement conductrice (343) sur une première face (342), et qui est délimitée par un pli unique (350, 450) par rapport à la première portion de substrat (330, 430), le pli étant tel que la deuxième portion de substrat est en contact avec ladite plaque de support (360, 460), **caractérisé en ce que** le module lumineux comprend un dispositif métallique représentant la masse, l'ensemble étant disposé sur une surface (312, 412) du dispositif métallique (310, 410), **en ce que** le pli étant tel que la trace électriquement conductrice (343) réalise une reprise de masse, et **en ce que** la plaque de support (360, 460) comprend deux parties qui s'étendent dans des plans généralement parallèles à la surface du dispositif métallique (312, 412), comprenant :
- une première partie (362, 462) dont une première face (363) est en contact avec la deuxième face (334) de la première portion de substrat (330) et dont une deuxième face (364), opposée à la première, est en contact avec la surface du dispositif métallique (312, 412), et
- une deuxième partie (366, 466) en contact avec la trace électriquement conductrice (343) de la première face (342) de la deuxième portion de substrat (340, 440).

2. Module lumineux selon la revendication 1, **caractérisé en ce que** le pli (350, 450) du substrat (320, 420) est tel que la première portion de substrat (330, 430) et la deuxième portion de substrat (340, 440) s'étendent l'une à côté de l'autre dans des plans généralement parallèles à la surface du dispositif métallique (312, 412).

3. Module lumineux selon une des revendications 1 à 2, **caractérisé en ce que** la plaque de support (360, 460) comprend une ouverture permettant le passage du substrat flexible (320, 420) au niveau du pli (350, 450).

4. Module lumineux selon une des revendications 1 à 3, **caractérisé en ce que** le dispositif métallique (310, 410) fait partie de moyens de dissipation thermique du module.

5. Module lumineux selon une des revendications 1 à 4, **caractérisé en ce que** les contacts entre le substrat (320, 420) et la plaque de support (360, 460) et/ou la surface du dispositif métallique (312, 412) sont réalisés à l'aide d'une colle thermiquement conductrice.

6. Module lumineux selon une des revendications 1 à 5, **caractérisé en ce que** les contacts entre la plaque de support (360, 460) et le substrat (320, 420) et/ou la surface du dispositif métallique (312, 412) sont réalisés à l'aide d'une colle thermiquement conductrice.

7. Module lumineux selon une des revendications 1 à 6, **caractérisé en ce que** le substrat flexible (320, 420) ou la plaque de support (360, 460) sont fixés au dispositif métallique à l'aide d'au moins un rivet perçant le substrat ou la plaque de support.

8. Module lumineux selon une des revendications 1 à 7, **caractérisé en ce que** le circuit électronique comprend des moyens de pilotage de l'alimentation d'au moins une source lumineuse du module lumineux.

9. Module lumineux selon une des revendications 1 à 8, **caractérisé en ce que** le circuit électronique comprend au moins une source lumineuse, par exemple à élément semi-conducteur.

## Patentansprüche

1. Leuchtmodul (300, 400) für ein Kraftfahrzeug, umfassend:
eine Anordnung, die eine Leiterplatte mit flexiblem Substrat (320, 420), FPCB, auf der eine elektronische Schaltung angeordnet ist, und mindestens eine elektrisch leitende Trägerplatte (360, 460) umfasst,
wobei das flexible Substrat einen ersten Substratabschnitt (330, 430) umfasst, welcher auf einer ersten Seite (332, 432) mindestens eine elektronische Komponente (333, 433) der elektronischen Schaltung trägt und welcher sich über eine der ersten Seite gegenüberliegende zweite Seite (334, 434) mit der Trägerplatte (360, 460) in Kontakt befindet, derart, dass der erste Substratabschnitt versteift wird,
wobei das flexible Substrat einen zweiten Substratabschnitt (340, 440) umfasst, welcher mindestens eine elektrische Leiterbahn (343) auf einer ersten Seite (342) umfasst und welche durch einen einzigen Knick (350, 450) in Bezug auf den ersten Substratabschnitt (330, 430) begrenzt wird, wobei der Knick so beschaffen ist, dass sich der zweite Substratabschnitt mit der Trägerplatte (360, 460) in Kontakt befindet,
**dadurch gekennzeichnet, dass** das Leuchtmodul eine metallische Vorrichtung umfasst, die Masse darstellt, wobei die Anordnung auf einer Fläche (312, 412) der metallischen Vorrichtung (310, 410) angeordnet ist, dadurch, dass der Knick so beschaffen ist, dass die elektrische Leiterbahn (343) eine Erdung bewirkt, und dadurch, dass die Trägerplatte (360, 460) zwei Teile umfasst, welche sich in Ebenen erstrecken, die im Wesentlichen parallel zu der Fläche (312, 412) der metallischen Vorrichtung sind, umfassend:
- einen ersten Teil (362, 462), von dem sich eine erste Seite (363) in Kontakt mit der zweiten Seite (334) des ersten Substratabschnitts (330) befindet und von dem sich eine zweite Seite (364), die der ersten gegenüberliegt, in Kontakt mit der Fläche (312, 412) der metallischen Vorrichtung befindet, und
- einen zweiten Teil (366, 466), der sich in Kontakt mit der elektrischen Leiterbahn (343) der ersten Seite (342) des zweiten Substratabschnitts (340, 440) befindet.

2. Leuchtmodul nach Anspruch 1, **dadurch gekennzeichnet, dass** der Knick (350, 450) des Substrats (320, 420) so beschaffen ist, dass sich der erste Substratabschnitt (330, 430) und der zweite Substratabschnitt (340, 440) nebeneinander in Ebenen erstrecken, die im Wesentlichen parallel zur Fläche (312, 412) der metallischen Vorrichtung sind.

3. Leuchtmodul nach einem der Ansprüche 1 bis 2, **dadurch gekennzeichnet, dass** die Trägerplatte (360, 460) eine Öffnung umfasst, die den Durchgang des flexiblen Substrats (320, 420) am Knick (350, 450) ermöglicht.

4. Leuchtmodul nach einem der Ansprüche 1 bis 3, **dadurch gekennzeichnet, dass** die metallische Vorrichtung (310, 410) Teil von Wärmeableitungsmitteln des Moduls ist.

5. Leuchtmodul nach einem der Ansprüche 1 bis 4, **dadurch gekennzeichnet, dass** die Kontakte zwischen dem Substrat (320, 420) und der Trägerplatte (360, 460) und/oder der Fläche (312, 412) der metallischen Vorrichtung mithilfe eines wärmeleitfähigen Klebstoffs ausgeführt sind.

6. Leuchtmodul nach einem der Ansprüche 1 bis 5, **dadurch gekennzeichnet, dass** die Kontakte zwischen der Trägerplatte (360, 460) und dem Substrat (320, 420) und/oder der Fläche (312, 412) der metallischen Vorrichtung mithilfe eines wärmeleitfähigen Klebstoffs ausgeführt sind.

7. Leuchtmodul nach einem der Ansprüche 1 bis 6, **dadurch gekennzeichnet, dass** das flexible Substrat (320, 420) oder die Trägerplatte (360, 460) an der metallischen Vorrichtung mithilfe mindestens eines Niets befestigt ist, der das Substrat bzw. die Trägerplatte durchbohrt.

8. Leuchtmodul nach einem der Ansprüche 1 bis 7, **dadurch gekennzeichnet, dass** die elektronische Schaltung Mittel zur Steuerung der Stromversorgung mindestens einer Lichtquelle des Leuchtmoduls umfasst.

9. Leuchtmodul nach einem der Ansprüche 1 bis 8, **dadurch gekennzeichnet, dass** die elektronische Schaltung mindestens eine Lichtquelle umfasst, zum Beispiel eine Halbleiter-Lichtquelle.

## Claims

1. Luminous module (300, 400) for an automotive vehicle, comprising
an assembly comprising a flexible printed circuit board (320, 420) accommodating an electronic circuit, and at least one support plate (360, 460) electrically conductive,
wherein the flexible board comprises:
a first board section (330, 430) that bears on a first face (332, 432) at least one electronic component (333, 433) of the electronic circuit, and that makes contact, via a second face (334, 434) that is opposite the first face, with said support plate (360, 460) so that the first board section is rigidified,
the flexible board comprising a second board section (340, 440) that comprises at least one electrically conductive track (343) on a first face (342), and that is bounded by a single fold (350, 450) with respect to the first board section (330, 430), the fold being such that the second board section makes contact with said support plate (360, 460),
**characterized in that** the luminous module comprises a metal device representing the mass, the assembly being arranged on a surface (312, 412) of a metal device (310, 410), **in that** the fold is such that the electrically conductive track (343) forms a connection to ground, and **in that** the support plate (360, 460) comprises two parts which extend in planes generally parallel to the surface of the metal device (312, 412), comprising:
- a first part (362, 462), a first face (363) of which is in contact with the second face of the first board section (330) and a second face (364) of which, opposed to the first face, is in contact with the surface of metal device (312, 412), and
- a second part (366, 466) in contact with the electrically conductive track (343) of the fist face (342) of the second board section (340, 440).

2. Luminous module according to Claim 1, **characterised in that** the fold (350, 450) of the board (320, 420) is such that the first board section (330, 430) and the second board section (340, 440) extend beside one another in planes that are generally parallel to the surface of the metal device (312, 412).

3. Luminous module according to one of Claims 1 to 2, **characterised in that** the support plate (360, 460) comprises an aperture allowing the passage of the flexible board (320, 420) level with the fold (350, 450).

4. Luminous module according to one of Claims 1 to 3, **characterised in that** the metal device (110, 210, 310, 410) is part of a heat-dissipating means of the module.

5. Luminous module according to one of Claims 1 to 4, **characterised in that** the contacts between the board (320, 420) and the support plate (360, 460) and/or the surface of the metal device (312, 412) are produced using a thermally conductive adhesive.

6. Luminous module according to one of Claims 1 to 5, **characterised in that** the contacts between the support plate (360, 460) and the board (320, 420) and/or the surface of the metal device (312, 412) are produced using a thermally conductive adhesive.

7. Luminous module according to one of Claims 1 to 6, **characterised in that** the flexible board (320, 420) or the support plate (360, 460) are fastened to the metal device using at least one rivet piercing the board or the support plate.

8. Luminous module according to one of Claims 1 to 7, **characterised in that** the electronic circuit comprises means for controlling the power supply of at least one light source of the luminous module.

9. Luminous module according to one of Claims 1 to 8, **characterised in that** the electronic circuit comprises at least one light source, for example comprising one or more semiconductor elements.
